# EUROPEAN PATENT APPLICATION

(11) **EP 0 766 138 A2**
(43) Date of publication of application: **02.04.1997**
(21) Application number: 96306755.8
(22) Date of filing: 17.09.1996
(51) Int. Cl.: G03F 1/08, G03F 7/09

(54) **Spun-on glass layer as a dry etch-mask, for fabricating a metallic mask by means of a bi-level process**

(30) Priority: 27.09.1995 US 534419
(71) Applicant: AT&T Corp., New York, NY 10013-2412 (US)
(72) Inventor: Kook, Taeho, Macungie, Pennsylvania 18062 (US)
(74) Representative: Johnston, Kenneth Graham

(57) **Abstract**

A metallic mask is fabricated by using a patterned spun-on glass layer located on an initially uniformly thick metallic layer. In turn, the metallic layer is located on a transparent substrate such as quartz. Patterning of the spun-on glass layer is performed by means of an anistropic dry-etching step, using (as a dry-etch protective layer) an overlying patterned resist that has been patterned by means of a direct-writing electron beam followed by wet development. The patterned spun-on glass layer is used as a dry-etch protective layer during a subsequent anisotropic dry-etch patterning of the metallic layer. After the metallic layer thus has been patterned, the spun-on glass layer can be removed by means of a dilute aqueous solution of hydrofluoric acid.

## Description

### Field of Invention:

This invention relates to methods of fabricating masks, and more particularly to fabricating photolithographic masks for use in fabricating such devices as semiconductor integrated circuit devices. These masks are also called "reticles" particularly when they are used in photolithography systems having magnifications different from unity.

### Background of Invention:

As known in the art, semiconductor integrated circuit devices are fabricated by a variety of steps in which a semiconductor wafer is subjected to various patterned processing steps. As used herein, the term "patterned processing steps" refers to the fact that each of such steps does not affect an entire major surface of the wafer but affects only selected portions of the major surface. These steps can include such steps as patterned deposition of layers, patterned impurity doping, or patterned etching. In this way, features are said to be formed at the major surface of the wafer. As used herein the term "semiconductor wafer" can include a semiconductor workpiece, that is, a semiconductor wafer that has already been subjected to processing steps.

A typical method of subjecting a wafer to patterned processing steps involves the use of various patterned photoresist layers, each located in contact with a major surface of the wafer to protect the wafer from each of the processing steps at only selected portions of the wafer. In order to obtain a patterned photoresist layer, the material of the photoresist is first deposited as a photoresist layer located everywhere in contact with the major surface of the wafer. Optical radiation is then directed at only the selected portions or only at the non-selected portion of the photoresist layer, depending on whether the photoresist is a negative or a positive photoresist, respectively. Next, the photoresist layer is developed, whereby the photoresist layer remains intact only at the thus previously selected portions (i.e., optically exposed portions *versus* optically unexposed portions, depending on whether the photoresist is negative or positive, respectively). The exposure of the photoresist layer to optical radiation at only selected portions of the layer typically is achieved by means of a photolithographic method. In that method a flood beam is directed at a patterned mask, typically a patterned metallic mask. The resulting patterned beam of optical radiation is focused on the photoresist layer located in contact with the wafer. Thus the patterned photoresist layer located on the major surface of the wafer acts as a patterned protective layer against whatever processing step is to be performed on the wafer.

The patterned metallic mask itself is typically a patterned metallic layer, such as a patterned chrome layer, located on a major surface of an optically transparent slab, such as a slab of glass or quartz . In prior art, this patterned metallic mask typically would be obtained by depositing a suitable resist layer everywhere in contact with a major surface of a mask substrate. The mask substrate initially is typically a metallic layer, such as chrome, located everywhere with uniform thickness on a major surface of the optically transparent slab. The resist layer is typically a photoresist layer that is also sensitive to an electron beam or to some other beam of actinic radiation. The actinic radiation, typically a direct-writing electron beam, is directed at only selected portions of this resist layer. Then this resist layer is subjected to a wet development (wet etching) step. The sidewalls of the resulting patterned resist layer, however, are not vertical (i.e., are not anisotropic). At any rate, the resulting patterned resist layer remains on the major surface of the metallic layer only at the thus previously selected portions. That is to say, those portions (and only those portions) of the resist layer that remain intact are those portions that were exposed *versus* were unexposed to the beam of actinic radiation, depending on whether the resist is negative or positive, respectively. The chrome layer is then patterned by wet or dry etching, using the patterned resist layer located on the major surface of the metallic layer as a protective mask against the etching. Typically, the patterned resist layer would then be removed.

A patterned metallic layer as fabricated in this way suffers from a problem in that the sidewalls (edges) of the resulting patterned metallic layer underlying the patterned resist layer are not vertical-that is, are not anisotropic and are not as predictable (controllable) as to precise lateral location as would be desired. More specifically, it is believed that, in cases in which patterning the chrome layer was performed by means of dry etching, the resulting sidewalls of the resist layer (not being anisotropic from the beginning) did not remain laterally fixed during the dry etching, whereby the subsequent etching of the underlying chrome layer was not anisotropic and the precise locations of the sidewalls of the resulting patterned chrome layer were not as predictable as desired. It is believed that this lack of predictability (lack of pattern fidelity) stems from poor dry-etch resistance of available resists. In cases in which patterning the chrome layer was performed by means of wet etching, it is believed that an undercutting of the resist layer (lateral etching of the chrome layer) resulted in an undesirble loss of line width, as well as a similar lack of anisotropy and lack of predictability of the locations of the resulting sidewalls of the underlying chrome layer. Therefore, when using either wet or dry etching to pattern the chrome layer, the sidewalls of the resulting patterned chrome layer suffered from a further lack of anisotropy and lack of controllability. In either case, the resulting mask thus was composed of a patterned chrome layer located on unpatterned transparent substrate. However, the sidewalls of the patterned chrome layer thus suffered from a lack of anisotropy and precise predictability. Therefore during subsequent use (for photolithographic purposes) of this resulting mask, the edges of the features of the mask (i.e., the sidewalls of the chrome layer) focused by the optical beam on the photoresist layer located on the wafer are not as predictable as desired. Hence, ultimately the edges of the features that are defined in the wafer are not as predictable as desired, especially in cases in which the feature size on the wafer is approximately 0.35 µm or less.

In U.S. Patent No. 4,774,164 a method of making a chrome mask was taught in which a layer of chrome was deposited everywhere on a major surface of a substrate such as glass or quartz. A patterned photoresist layer, which had been patterned with an electron beam, was then formed over the top surface of the chrome layer. Next, an unpatterned glass layer, such as a spun-on glass layer, was deposited everywhere over the top surface of the entire structure being fabricated. This glass layer was thereafter planarized. More specifically, this glass layer was dry-etched downward by a sufficient distance to ensure that the top surface of the patterned photoresist layer was fully uncovered. Thus the pattern of this patterned photoresist layer became exposed. The patterned photoresist layer was then removed, whereby the top surface of the chrome layer was exposed except at areas coated by the patterned glass layer. In this way, regions where the patterned photoresist layer previously existed became vacant, whereby the glass layer became a patterned glass layer having sidewalls extending all the way down to the underlying metallic layer. This resulting patterned glass layer was then used as a dry-etch mask for etching the metallic layer. In this way, a patterned metallic layer was formed.

A problem with the foregoing approach is that the required glass planarization step is expensive. Moreover, the planarization step is not easily controlled in such a manner as not to etch too much or too little of the spun-on glass. Moreover, because of the nonplanar topology underlying the spun-on glass layer, the planarization step suffers from an undesirable localized phenomenon: namely, the thickness of the spun-on glass layer varies with the underlying topology. Consequently, the planarization step imposes undesirable limitations on the smallness of sizes of feature and spaces between features.

Therefore it would be desirable to have a method of making a patterned metallic mask that alleviates at least some of the shortcomings of prior art.

### Summary of Invention:

This invention involves, in a specific embodiment, a method of fabricating a mask comprising the steps of
(a) providing a body comprising a transparent slab, advantageously comprising quartz, at a top major surface of the slab, on a major surface of which are located
   a metallic layer, advantageously comprising chrome and advantageously having a uniform thickness,
   a spun-on (or other relatively low-temperature-deposited) glass layer, advantageously having a uniform thickness, located on a top major surface of the metallic layer, and
   a patterned photoresist layer on a top major surface of the spun-on glass layer;
(b) dry etching the spun-on glass (or other relatively low-temperature-deposited) layer but not the metallic layer, using the patterned photoresist layer as a protective layer against etching, whereby a patterned spun-on (or other relatively low-temperature-deposited) glass layer is formed;
(c) dry-etching the metallic layer but not the slab, using the patterned spun-on glass (or other relatively low-temperature-deposited) layer as a protective mask against etching,

Advantageously, the spun-on glass (or other relatively low-temperature-deposited) layer is then removed by means of a wet etching with a solution of dilute hydrofluoric acid.

### Brief Description of the Drawings:

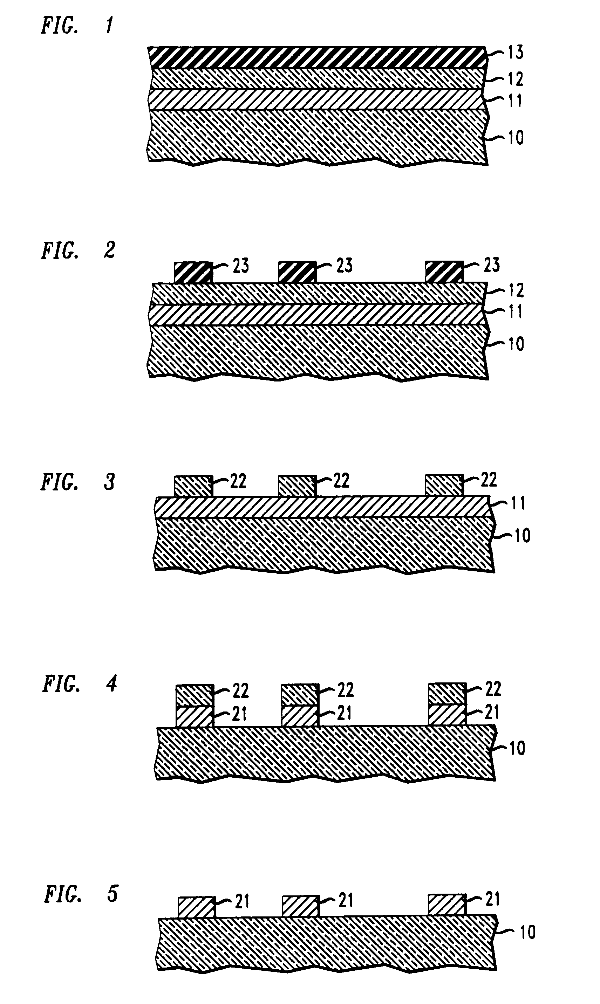

FIGS. 1-5 are cross-section diagrams of a metallic mask in various stages of fabrication according to a specific embodiment of the invention.

Only for the sake of clarity, none of the FIGURES is drawn to any scale.

### Detailed Description:

As shown in FIG. 1, a transparent substrate 10, typically composed of quartz, has a top major surface having an area of approximately 150 mm x 150 mm. A metallic layer 11 is deposited on this top major surface of the substrate 10. Typically this metallic layer 11 is composed of chrome having a substantially uniform thickness of typically approximately 100 nm or more. A spun-on glass layer 12 is then formed everywhere on a top major surface of the metallic layer 11. Typically the spun-on glass layer 12 is formed at a temperature of approximately 200°C. Also, the spun-on glass layer 12 advantageously has a substantially uniform thickness in a useful approximate range of 100-to-200 nm, typically 120 nm. Next, a resist layer 13 is deposited everywhere on the top surface of the spun-on glass layer 12, advantageously to a substantially uniform thickness. Typically the resist layer is typically AZ5206 obtainable from Hoechst Celanese Corporation, whose address is Electronics Products Division, 3070 Highway 22 West, Somerville, New Jersey 08876.. Typically this resist layer 13 is deposited to a thickness of approximately 600 nm.

The resist layer 13 (FIG. 1) is then patterned, such as by means of a direct-writing electron beam followed by a wet development, as known in the art, whereby a patterned resist layer 23 (FIG. 2) is formed. Next, the top surface of the resulting structure (FIG. 2) is subjected to a dry etching step that attacks the spun-on glass layer 12 but not the metallic layer 11. In this way the dry etching step produces a patterned spun-on glass layer 22 (FIG. 3). For example, this dry etching advantageously is performed with gaseous CHF₃, whereby the result of this etching is nearly perfectly anisotropic; that is to say, this etching produces nearly perfectly vertical sidewalls in the patterned spun-on glass layer 22. Then the resist layer 23 typically is completely removed ("stripped"), in order to provide better control of subsequent dry etching of the metallic layer 11.

Next, the portions of the metallic layer 11 (FIG. 3) whose top surfaces are not coated with the patterned spun-on glass layer are removed by a dry anisotropic etching step using the patterned spun-on glass layer 22 as a protective mask against the etching. For example, in case the metallic layer 11 comprises chrome, plasma etching of the chrome with a gaseous mixture of chlorine and oxygen is useful. The structure shown in FIG. 4 is useful as a reticle, except in cases of an attenuating phase-shifting reticle. In case an attenuating phase-shifting reticle is desired, the patterned spun-on glass layer 22 can be removed (FIG. 5), preferably by means of a wet etching with a dilute aqueous solution of HF so as not to attack the substrate 10. To this end, advantageously the aqueous solution contains HF in a concentration ratio (H₂O:HF) in the approximate volumetric range of 50: 1-to-200: 1: typically a ratio of approximately 100:1. Typically this wet etching with dilute aqueous HF solution is performed at a temperature of 20°C. Such an etching solution at this temperature has a relatively high selectivity, namely, of more than 10:1, for the spun-on glass layer 22 than for the substrate 10 when the substrate 10 is made of quartz. The structure shown in FIG. 5 is also useful as a reticle or as a basis for fabricating an attenuating phase-shifting mask by means of further processing steps as known in the art. The above-mentioned relatively high selectivity of the etching by the HF solution is especially important when the structure shown in FIG. 5 is used as a basis for fabricating an attenuating phase-shifting mask.

Although the invention has been described in detail with respect to a specific embodiment, various modifications can be made without departing from the scope of the invention. Thus, for example, since low-temperature-deposited glass etches (e.g., in dilute HF) faster than does either quartz or high-temperature-deposited glass, instead of spun-on glass, the glass layer 12 can be a glass layer that has been deposited at a relatively low temperature, such as in the approximate range of 20°C-to-300°C, don't want to guess, typically approximately 200°C. Instead of quartz, the substrate 10 can comprise other optical material that has been used for mask fabrication, provided such material has a lower etch rate than the spun-on glass or the other relatively low temperature deposited oxide, as the case may be.

## Claims

1. A method of fabricating a patterned mask comprising the steps of a method of fabricating a mask comprising the steps of
(a) providing a body comprising a transparent slab at a top major surface of the slab, on a major surface of which are located
a metallic layer having a substantially uniform first thickness,
a glass layer, having a substantially uniform second thickness, located on a top major surface of the metallic layer, and
a patterned photoresist layer on a top major surface of the glass layer:
(b) dry etching the glass layer but not the metallic layer, using the patterned photoresist layer as a protective layer against etching, whereby a patterned glass layer is formed;
(c) dry-etching the metallic layer but not the slab, using the patterned spun-on glass layer as a protective mask against etching.

2. The method of claim 1, in which the transparent slab comprises glass, and in which the method further comprises the steps of forming the transparent slab at a first temperature and depositing the glass layer at a second temperature that is substantially lower than the first temperature.

3. The method of claim 2, in which the glass layer is formed by spinning it on the metallic layer.

4. The method of claim 1 or 2, or 3, in which the metallic layer comprises chrome.

5. The method of claim 1 or 2 or 3 in which the slab comprises quartz.

6. The method of claim 1 in which the glass layer is formed by spinning it on the top major surface of the metallic layer.

7. A method comprising the steps recited in claim 1,2,3,4, 5 or 6 followed by the step of removing the patterned glass layer by means of a wet etching step.

8. The method of claim 7, in which the wet etching step is performed by means of an aqueous solution comprising HF.

9. The method of claim 8, in which the aqueous solution contains HF in a concentration ratio of HF:H₂O in the approximate range of 50:1-to-200:1.
